# EUROPEAN PATENT SPECIFICATION

(11) **EP 3 015 307 B1**
(45) Date of publication and mention of the grant of the patent: **22.01.2020**
(21) Application number: 15186567.2
(22) Date of filing: 23.09.2015
(51) Int. Cl.: B60L 50/50

(54) **EVSE SHORTED CABLE PROTECTION METHOD**
EVSE-KURZSCHLUSS-KABELSCHUTZVERFAHREN
PROCÉDÉ DE PROTECTION DE CÂBLE COURT-CIRCUITÉ EVSE

(30) Priority: 31.10.2014 US 201414529793
(43) Date of publication of application: 04.05.2016
(73) Proprietor: Schneider Electric USA, Inc., Boston, MA 02108 (US)
(72) Inventor: JEFFERIES, Kevin M., Boston, MA 02108 (US); EDWARDS, Benjamin W., Boston, MA 02108 (US); WHITE, Matthew L., Boston, MA 02108 (US); FILIPPENKO, Konstantin A., Boston, MA 02108 (US); WEILER, Richard K., Boston, MA 02108 (US)
(74) Representative: Murgitroyd & Company

(56) References cited:
- WO-A2-2014/036013
- JP-A- 2013 027 144
- US-A1- 2012 098 490
- US-A1- 2012 249 070
- US-A1- 2014 232 182

## Description

### BACKGROUND OF THE INVENTION

### 1. FIELD OF THE INVENTION

The invention disclosed relates to electric vehicle supply equipment.

### 2. DISCUSSION OF THE RELATED ART

Plug-in electric vehicles (EVs), including all-electric cars, neighborhood electric vehicles and plug-in hybrids, are becoming a popular mode for personal transportation, in part because they are less expensive to operate and have a reduced carbon footprint. Electric vehicle charging stations, also called Electric Vehicle Supply Equipment (EVSE), provide power to an EV through a standardized interface. The most common interface is defined by industry standard SAE J1772. The interface includes defined control signals, ground, and a high ampere current path. In the Level 2 alternating current (AC) charging standard, the EVSE may provide up to 80A charging current to the connected EV.

The EVSE includes a relay or contactor to disconnect the power poles providing charging energy to the electric vehicle (EV) from the incoming power provided to the EVSE. Electromechanical contacts in the relay or contactor are subject to specific failure modes, for example the welding of contacts. Contact welding can occur when the contacts are subjected to sufficient current to cause the contact material to melt, such as when the load connection experiences a short circuit. Such situations may occur in the charging cable, which typically includes five or more meters of cable exposed to the environment. The charging cable may be severely bent, dropped, pulled on and run over by a vehicle. Such misuse is expected and is difficult to avoid, since the charging cable has to be long enough to accommodate different types of vehicles. Patent application WO2014/036013 A2 (Aerovironment Inc.) disloses an EVSE having detection of various fault conditions, including welded relay contacts, low impedance and output line fault.

Preventive measures can be taken to protect relay or contactor contacts from welding under specific conditions, for example coordination can be applied with upstream protective devices, such as fuses or circuit breakers. However, replacing fuses or resetting breakers, requires proper diagnosis of the fault and clearing of the fault by authorized maintenance personnel. Until such maintenance is performed, the welded contacts of the relay or contactor leave the EVSE inoperable and unusable.

Present solutions are available for detecting short circuits, but have not been applied to protecting EVSE relay or contactor contacts from welding.

### SUMMARY OF THE INVENTION

The subject invention uses short circuit detection in an EVSE, before main power contactors in the EVSE are closed, to prevent power from being delivered to the charging handle when a fault is detected in the charging cable. The subject invention does not require that the charging cable be connected to an EV, in order to perform a test. An impedance measuring circuit and control electronics are included in the EVSE to measure the resistance between the cable conductors before the cable is connected to an EV. The main current carrying conductors in the cable are the L1, L2 or N, and ground conductors. The resistance between any two of these conductors is measured by the impedance measuring circuit. If the measured resistance is less than a threshold resistance value, the control electronics identifies that a short circuit condition exists between the two conductors being tested. In response, the control electronics outputs a protection signal to the contactors in the EVSE, to prevent them from being closed. A pilot signal indicating that the charging cable has become connected to the EV, will terminate said impedance test. A warning signal may also be generated, to notify the user that a short has been detected in the charging cable.

The impedance measuring circuit includes a multiplexer controlled by the control electronics, to sequentially connect pairs of the L1, L2 or N, and ground conductors for resistance measurement. The control electronics may control the impedance measurement circuit to perform an impedance measurement between sequentially selected pairs of conductors of the charging cable. The measurement may be repeated at intervals to monitor the integrity of the conductors over time. The control electronics may be configured to output the identity of shorted conductors for appropriate maintenance action. The control electronics may be configured to record the results of the impedance tests for pairs of the conductors, to compile a maintenance history. The control electronics may be configured to disable the impedance measurement circuit in response to receiving a signal indicating that the charging cable has become connected to an electric vehicle.

In this manner, by detecting a short circuit in the charging cable before the contactors are closed, the EVSE relay or contactor contacts are protected from being welded closed.

### BRIEF DESCRIPTION OF THE FIGURES

Figure 1 is a functional block diagram of an example EVSE with an impedance measurement circuit in the EVSE, configured to measure impedance between different pairs of conductors of the charging cable while the charging cable is not connected to an electric vehicle.
Figure 2 is a functional block diagram of an example impedance measurement circuit and control electronics in the EVSE, configured to sequentially perform impedance measurement between different pairs of conductors of the charging cable while the charging cable is not connected to an electric vehicle.
Figure 3 is a functional block diagram of the example control electronics in the EVSE, including pilot signal measurement, microprocessor, and memory components.

### DETAILED DESCRIPTION OF EMBODIMENTS OF THE INVENTION

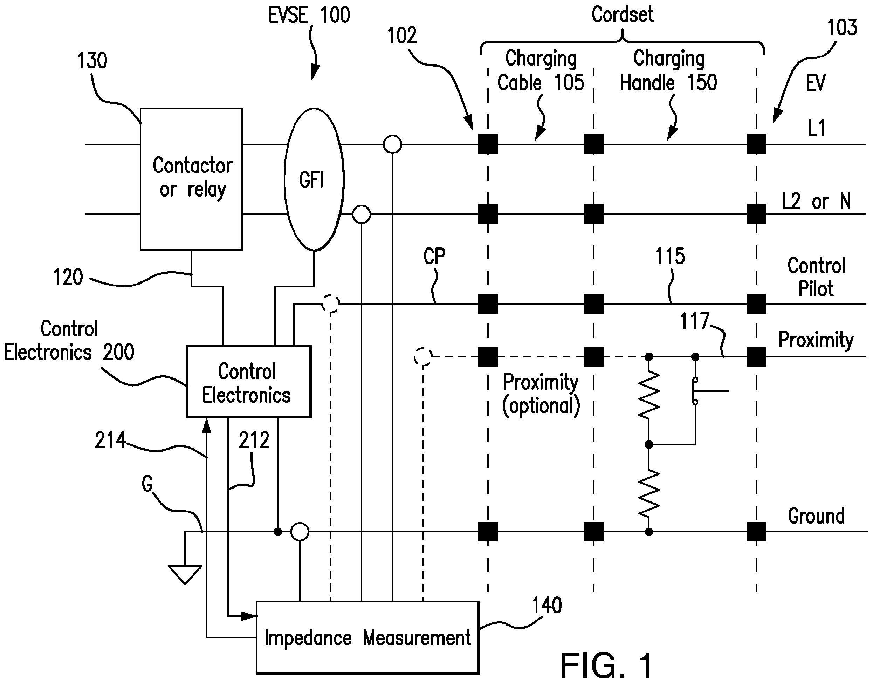

Figure 1 is a functional block diagram of an example Electric Vehicle Supply Equipment (EVSE) 100 and a charging cable 105 connected from the charging output port 102 of the EVSE to the onboard input port 103 of the electric vehicle (EV). A charging handle 150 is connected to the opposite end of the cable from the EVSE and is configured to plug into the onboard input port 103 of the electric vehicle (EV), for charging operations. The charging cable 105 has two power conductors L1 and L2 or N (neutral), a ground conductor G, and a control pilot conductor 115. The power conductors L1 and L2/N receive power through a contactor or relay 130 in the EVSE. The control pilot conductor 115 in the charging cable 105 carries a control pilot signal CP that functions to verify to the EVSE that an EV is present and connected to the charging handle 150, for example as described in the SAE J1772 standard.

The charging cable 105 may be subjected to physical stresses during normal use by users who inadvertently pull on, drop, or run over the cable. The charging cable 105 typically delivers up to 30 Amperes of current at approximately 208 or 240 volts when charging an EV. Any damaged section along the cable 105 having a low resistance between the current-carrying conductors L1 and L2/N or the ground conductor G, may conduct sufficient current to cause upstream contacts of the relay or contactor 130, to weld closed.

In an example embodiment of the invention, an impedance measurement circuit 140 is incorporated in the EVSE, to measure impedance between different pairs of the conductors L1, L2/N, and ground G of the charging cable 105. The impedance measurements are limited to occur only during periods when the charging cable 105 and its charging handle 150 are not connected to an EV, so as to not interfere with normal vehicle charging operations.

Control electronics 200 are also incorporated in the EVSE, including a sensing circuit connected to the control pilot conductor 115, to receive the control pilot signal CP. The control electronics 200 determines from the control pilot signal CP whether the charging handle 150 of the charging cable 105 is connected to an EV. The control electronics 200 is connected over line 212 to the impedance measurement circuit 140, to control the impedance measurement circuit 140 to conduct impedance measurements only during periods when the charging cable 105 and its charging handle 150 are not connected to an EV.

The control electronics 200 is connected over an input line 214 from the impedance measurement circuit 140. If the impedance measurement circuit 140 measures a low resistance between any pair of the current-carrying conductors L1 and L2/N or the ground conductor G, the impedance measurement circuit 140 sends an alert signal on line 214 to the control electronics 200, signaling that it has detected a short between two of the conductors. If an impedance measurement result is outside of acceptable limits, the impedance measurement circuit 140 signals that condition. The control electronics 200 may be configured to output the identity of shorted conductors for appropriate maintenance action.

The control electronics 200 is connected over line 120 to the contactor or relay 130. A protection circuit in the control electronics 200 is configured to send a protection signal over line 120 to the contactor or relay 130 in response to the impedance measurement circuit 140 detecting a short between the conductors. When the contactor or relay 130 receives the protection signal on line 120, it prevents closure of the contacts in the contactor or relay 130, preventing power to be applied from the power source to the conductors L1 and L2/N of the charging cable 105.

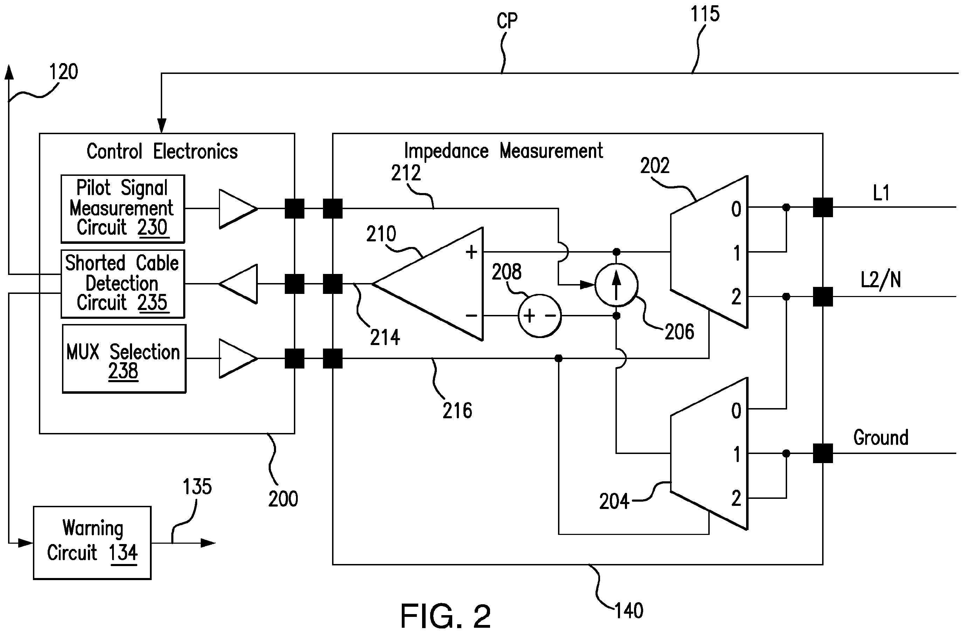

The control electronics 200 may include a warning circuit 134 (shown in Figure 2), configured to output a warning signal 135 (shown in Figure 2), to an annunciator such an LED display (not shown), in response to the impedance measurement circuit 140 detecting a short between the conductors L1 and L2/N or the ground conductor G. The warning circuit may output the identity of the shorted conductors, which may be displayed by LED lights on the EVSE or which may be sent in an email message. The warning circuit may output a notification on a mobile application to the owner of the EVSE for appropriate maintenance action. The same notification may be delivered to a service maintenance organization that may be responsible for the up-time of the EVSE.

In example embodiments of the invention, the impedance measurement circuit 140 may also measure and detect a short circuit condition in the control pilot conductor 115 or the proximity conductor 117. This may provide additional detection of conditions that might impair or prevent proper operation of the EVSE. The impedance measurement circuit 140 may be configured to detect a short circuit condition from L1 or L2/N to the control pilot conductor 115 or the proximity conductor 117 as a short circuit to ground, due to a relatively low impedance to ground of these conductors.

The proximity conductor 117 is connected to a proximity switch in the charging handle 150, which detects initial insertion of the charging handle 150 into the vehicle inlet, before any electrical contact is established, for example as described in the SAE J1772 standard. In an alternate example embodiment of the invention, the control electronics 200 may determine from the proximity conductor 117 whether initial insertion of the charging handle 150 into the vehicle inlet has occurred, before any electrical contact is established. In this alternate example embodiment, the control electronics 200 may control the impedance measurement circuit 140 to conduct impedance measurements only during periods when the charging handle 150 has not been initially inserted into the vehicle inlet.

Figure 2 is a functional block diagram of the impedance measurement circuit 140 and the control electronics 200 incorporated in the EVSE. Control electronics 200 includes the pilot signal measurement circuit 230 that is a sensing circuit connected to the control pilot conductor 115, to receive the control pilot signal CP. The control electronics 200 is connected over line 212 to the impedance measurement circuit 140, to control the impedance measurement circuit 140 to conduct impedance measurements only during periods when the charging cable 105 and its charging handle 150 are not connected to an EV.

The impedance measurement circuit 140 includes for example a multiplexer circuit comprising multiplexer switches 202 and 204 that are configured to enable sequentially measuring impedance between different pairs of conductors L1, L2/N and ground G of the charging cable 150, while the charging cable is not connected to an EV. The impedance measurement checks the impedance between combinations of pairs of the conductors. Multiplexer switch 202 is connected to the L1 and L2/N conductors and multiplexer switch 204 is connected to the L2/N and ground G conductors. The MUX selection 238 of the control electronics 200, is connected over line 216 to the multiplexer switches 202 and 204, to enable sequentially performing an impedance test between different pairs of the conductors L1, L2/N and ground G of the charging cable 105, while the charging cable is not connected to an EV. This arrangement allows the control electronics 200 to control which combination of conductors L1, L2, and ground G the impedance measurement circuit 140 measures at any given time.

In alternate embodiments, the MUX selection 238 signal on line 216 may be generated by the control electronics 200 when the pilot signal measurement circuit 230 indicates that there is no connection to an EV. In example embodiments, other methods of impedance measurement may be used and other methods of selecting conductors to test may be used.

In an example embodiment, the impedance measurement circuit 140 includes a current source 206 connected between the output of multiplexer switch 202 and the output of multiplexer switch 204. The output of multiplexer switch 202 is connected to the plus side of the differential amplifier 210. The output of multiplexer switch 204 is connected through a voltage source, such as a battery, to the minus side of the differential amplifier 210. For a given combination of two of the conductors L1, L2/N and ground G, if there is no short between the two conductors, then no current flows through the current source 206 and the differential amplifier 210 does not out put an alert signal on line 214 to the control electronics 200. Alternately, if there is a short detected between the two conductors, then current flows through the current source 206 and the differential amplifier 210 outputs an alert signal on line 214 to the control electronics 200. The control electronics 200 may be configured to output the identity of shorted conductors for appropriate maintenance action. When the pilot signal measurement circuit 230 receives a control pilot signal CP indicating that an EV is connected, the pilot signal measurement circuit 230 sends a disabling signal on line 212 to the current source 206 to turn off the current source. In this manner, impedance measurements are not made when the charging cable 105 and its charging handle 150 are connected to an EV.

In example embodiments of the invention, the impedance measurement circuit 140 may be implemented using a voltage source or a current source. Figure 2 depicts a current source and voltage comparison to a threshold, to detect the impedance being below a threshold. The threshold value may be set sufficiently high so that a short to the control pilot conductor 115 or the proximity conductor 117 will appear as a short to ground. For example, the threshold value may be set to indicate an impedance below 1 Megohm as a shorted conductor connection.

Control electronics 200 includes the shorted cable detection circuit 235 that is a protection circuit connected to the line 214 from the impedance measurement circuit 140. If the shorted cable detection circuit 235 receives an alert signal on line 214, it sends a protection signal over line 120 to the contactor or relay 130, to prevent closure of the contacts in the contactor or relay 130, preventing power to be applied from the power source to the conductors L1 and L2/N of the charging cable 105. In addition, the shorted cable detection circuit 235 may send the protection signal to the warning circuit 134. The shorted cable detection circuit 235 may also send the identity of the shorted conductors to the warning circuit 134, to be displayed by the warning circuit for appropriate maintenance action by the owner of the EVSE. This allows a display of the shorted cable detection status for every combination of conductors tested, to indicate the precise problem to the owner or operator of the EVSE. The control electronics 200 may test the impedance of the conductors of the cable 105 and record the detection status for every pair of the conductors as maintenance records. The measurement may be repeated at intervals to monitor the integrity of the conductors over time.

Based on the detection, the EVSE may take various actions. The EVSE may prevent a user from unlatching the charging handle 150 from the EVSE, if equipped with a locking mechanism. The EVSE may display an error message or otherwise indicate unavailability to potential users. The EVSE may indicate to the owner or operator, for example by email communications, that the EVSE is unavailable and requires maintenance.

In an example embodiment, the control pilot signal CP on the control pilot conductor 115 may be specified in the SAE J1772 standard. The standard specifies that the control pilot signal CP functions to verify that the electric vehicle EV is present and connected, permits energization/de-energization of the supply, transmits supply equipment current rating to the vehicle, monitors the presence of the equipment ground, and establishes vehicle ventilation requirements. The control pilot signal CP on the control pilot conductor 115 specified in the SAE J1772 standard, is a 1 kHz square wave signal in the range of +12 and -12 volts. The control pilot signal CP uses its voltage to define the state of the charging transaction. If the 1 kHz square wave signal positive voltage is +12 volts, this indicates State A, that an EV is not connected . If the 1 kHz square wave signal positive voltage is +9 volts and the minus voltage as -12 volts, this indicates State B, that an EV is connected, but is not ready to receive a charge. The SAE J1772 standard specifies that the 1 kHz square wave signal positive voltage of +6 volts and the minus voltage as -12 volts, indicates State C, that the EV is ready to accept the charge. The EV performs this signaling to indicate the EVSE that the charging handle 150 is connected and the EV is ready to receive the charge.

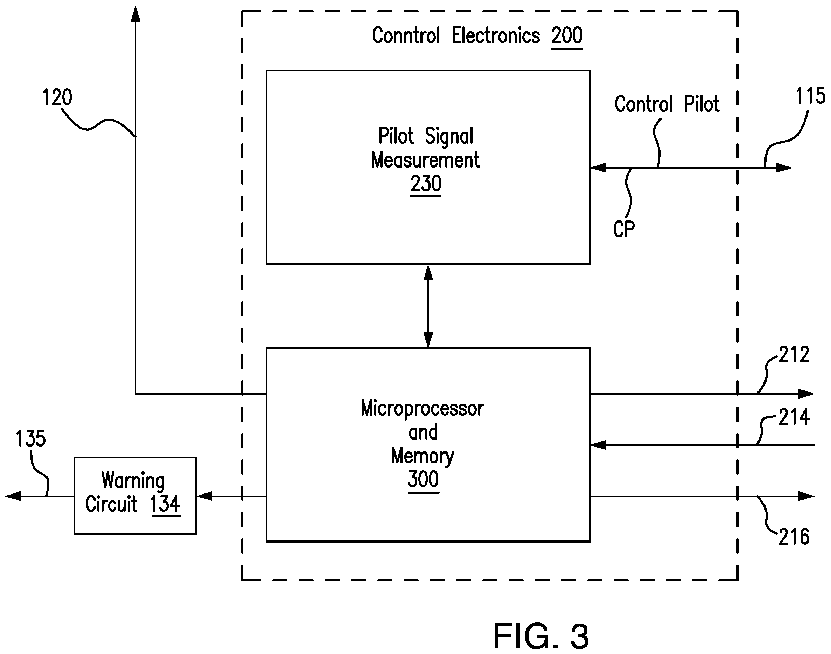

Figure 3 is a functional block diagram of an example control electronics 200 in the EVSE, including the pilot signal measurement module 230 and a microprocessor and memory 300. The microprocessor may be programmed and its associated memory may contain program instructions which, when executed by the microprocessor, carry out functions, for example, of the shorted cable detection circuit 235, the MUX selection 238, and the warning circuit 134. The microprocessor may receive CP signal status from the pilot signal measurement module 230, indicating whether an EV is connected to the cable 105. The microprocessor may be connected over line 212 to the impedance measurement circuit 140 to control the impedance measurement circuit 140 to conduct impedance measurements only during periods when the charging cable 105 and its charging handle 150 are not connected to an EV. The microprocessor may be programmed to receive the alert signal on line 214 and in response, send a protection signal over line 120 to the contactor or relay 130, to prevent closure of the contacts in the contactor or relay 130. The microprocessor may be programmed to output multiplexer selection signals on line 216 to enable sequentially performing an impedance test between different pairs of the conductors L1, L2/N and ground G, while the charging cable is not connected to an EV. The signal on line 216 may be generated when the pilot signal measurement circuit 230 indicates that there is no connection to an EV. The microprocessor may be programmed to cause a warning to be displayed and the display of the identity of the shorted conductors, for appropriate maintenance action by the owner of the EVSE. The microprocessor may be programmed to display the shorted cable detection status for every combination of conductors tested, to indicate the precise problem to the owner or operator of the EVSE. The microprocessor may be programmed to repeatedly test the impedance of the conductors of the cable 105 and record the detection status for every pair of the conductors as a maintenance history. The control electronics 200 may reuse an existing microprocessor and memory in the EVSE, with little or no modification required to the EVSE control electronics.

Although specific example embodiments of the invention have been disclosed, persons of skill in the art will appreciate that changes may be made to the details described for the specific example embodiments, without departing from the scope of the invention.

## Claims

1. A method for detecting a shorted charging cable of an electric vehicle charging station, comprising:
(a) sensing that a charging cable (105) of an electric vehicle charging station is not connected to an electric vehicle;
(b) performing an impedance test between conductors (L1, L2/N, and ground) of the charging cable while the charging cable is not connected to an electric vehicle;
(c) preventing closure of a contactor (130) between a source of electrical power and the conductors (L1, L2/N) of the charging cable in response to detecting a short between the conductors;
(d) receiving a control pilot signal indicating that the charging cable of the electric vehicle charging station has become connected to the electric vehicle, and said method **characterised in that** in further comprises the step of (e) terminating performing the impedance test between the conductors of the charging cable in response to the receipt of the control pilot signal.

2. The method for detecting a shorted charging cable of an electric vehicle charging station of claim 1, further comprising:
(f) outputting a warning signal in response to detecting a short between the conductors.

3. The method for detecting a shorted charging cable of an electric vehicle charging station of claim 1, further comprising:
sequentially performing an impedance test between different pairs of the conductors of the charging cable while the charging cable is not connected to an electric vehicle.

4. The method for detecting a shorted charging cable of an electric vehicle charging station of claim 1, wherein the contactor is protected from potential welding of its contacts by preventing closure of the contactor in response to detecting a short between the conductors.

5. The method for detecting a shorted charging cable of an electric vehicle charging station of claim 1, further comprising:
identifying any shorted conductors for appropriate maintenance action.

6. The method for detecting a shorted charging cable of an electric vehicle charging station of claim 1, further comprising:
repeating performance of an impedance test between conductors of the charging cable at intervals over time; and
recording results of the impedance tests for pairs of the conductors tested.

7. A circuit for detecting a shorted charging cable of an electric vehicle charging station, comprising:
(a) a sensing circuit (230) in an electric vehicle charging station, the sensing circuit being coupled to a control pilot line (115) of the electric vehicle charging station, the sensing circuit being configured to receive a control pilot signal indicating that a charging cable (105) of the electric vehicle charging station is not connected to an electric vehicle;
(b) an impedance measurement circuit (140) in the electric vehicle charging station, the impedance measurement circuit being coupled to the sensing circuit (230), the impedance measurement circuit being configured to perform an impedance test between conductors (L1, L2/N, and ground) of the charging cable (105) while the charging cable is not connected to an electric vehicle, and
(c) a protection circuit (235) in the electric vehicle charging station, the protection circuit being coupled to the impedance measurement circuit, the protection circuit being configured to prevent closure of a contactor (130) between a source of electrical power and the conductors of the charging cable (105) in response to the impedance measurement circuit (140) detecting a short between the conductors (L1, L2/N, and ground), **characterized in that** said impedance measurement circuit being coupled to the control pilot line of the electric vehicle charging station, the impedance measurement circuit being configured to receive a control pilot signal indicating that the charging cable of the electric vehicle charging station has become connected to the electric vehicle, and the impedance measurement circuit being configured to terminate performing the impedance test between the conductors of the charging cable in response to the receipt of the control pilot signal.

8. The circuit for detecting a shorted charging cable of an electric vehicle charging station of claim 7, further comprising:
(d) a warning circuit in the electric vehicle charging station, the warning circuit being coupled to the protection circuit, the warning circuit being configured to output a warning signal in response to detecting a short between the conductors.

9. The circuit for detecting a shorted charging cable of an electric vehicle charging station of claim 7, further comprising:
a multiplexer circuit in the electric vehicle charging station, the multiplexer circuit being configured to sequentially connect the impedance measurement circuit between different pairs of the conductors of the charging cable while the charging cable is not connected to an electric vehicle.

10. The circuit for detecting a shorted charging cable of an electric vehicle charging station of claim 7, wherein the contactor is protected from potential welding of its contacts by preventing closure of the contactor in response to detecting a short between the conductors.

11. The circuit for detecting a shorted charging cable of an electric vehicle charging station of claim 7, wherein shorted conductors are identified for appropriate maintenance action.

12. The circuit for detecting a shorted charging cable of an electric vehicle charging station of claim 7, wherein performance of an impedance test between conductors of the charging cable is repeated at intervals over time; and
control electronics in the electric vehicle charging station, the control electronics being configured to record results of the impedance tests for pairs of the conductors tested.

## Patentansprüche

1. Ein Verfahren zum Erkennen eines kurzgeschlossenen Ladekabels einer Elektrofahrzeug-Ladestation, das Folgendes beinhaltet:
(a) Erfassen, dass ein Ladekabel (105) einer Elektrofahrzeug-Ladestation nicht mit einem Elektrofahrzeug verbunden ist;
(b) Durchführen eines Impedanztests zwischen Leitern (L1, L2/N und Erde) des Ladekabels, während das Ladekabel nicht mit einem Elektrofahrzeug verbunden ist;
(c) Verhindern einer Schließung eines Relais (130) zwischen einer Quelle elektrischer Leistung und den Leitern (L1, L2/N) des Ladekabels als Reaktion auf das Erkennen eines Kurzschlusses zwischen den Leitern;
(d) Empfangen eines Steuerungspilotsignals, das anzeigt, dass das Ladekabel der Elektrofahrzeug-Ladestation mit dem Elektrofahrzeug verbunden worden ist, und wobei das Verfahren **dadurch gekennzeichnet ist, dass** es ferner den Schritt (e) des Beendens des Durchführens des Impedanztests zwischen den Leitern des Ladekabels als Reaktion auf den Empfang des Steuerungspilotsignals beinhaltet.

2. Verfahren zum Erkennen eines kurzgeschlossenen Ladekabels einer Elektrofahrzeug-Ladestation gemäß Anspruch 1, das ferner Folgendes beinhaltet:
(f) Ausgeben eines Warnsignals als Reaktion auf das Erkennen eines Kurzschlusses zwischen den Leitern.

3. Verfahren zum Erkennen eines kurzgeschlossenen Ladekabels einer Elektrofahrzeug-Ladestation gemäß Anspruch 1, das ferner Folgendes beinhaltet:
sequentielles Durchführen eines Impedanztests zwischen unterschiedlichen Paaren der Leiter des Ladekabels, während das Ladekabel nicht mit einem Elektrofahrzeug verbunden ist.

4. Verfahren zum Erkennen eines kurzgeschlossenen Ladekabels einer Elektrofahrzeug-Ladestation gemäß Anspruch 1, wobei das Relais durch das Verhindern einer Schließung des Relais als Reaktion auf das Erkennen eines Kurzschlusses zwischen den Leitern vor einem potentiellen Schweißen seiner Kontakte geschützt ist.

5. Verfahren zum Erkennen eines kurzgeschlossenen Ladekabels einer Elektrofahrzeug-Ladestation gemäß Anspruch 1, das ferner Folgendes beinhaltet:
Identifizieren jeglicher kurzgeschlossener Leiter für geeignete Wartungsmaßnahmen.

6. Verfahren zum Erkennen eines kurzgeschlossenen Ladekabels einer Elektrofahrzeug-Ladestation gemäß Anspruch 1, das ferner Folgendes beinhaltet:
Wiederholen der Durchführung eines Impedanztests zwischen Leitern des Ladekabels an Intervallen im Zeitablauf; und
Aufzeichnen von Ergebnissen der Impedanztests für Paare der getesteten Leiter.

7. Eine Schaltung zum Erkennen eines kurzgeschlossenen Ladekabels einer Elektrofahrzeug-Ladestation, die Folgendes beinhaltet:
(a) eine Erfassungsschaltung (230) in einer Elektrofahrzeug-Ladestation, wobei die Erfassungsschaltung an eine Steuerungspilotleitung (115) der Elektrofahrzeug-Ladestation gekoppelt ist, wobei die Erfassungsschaltung konfiguriert ist, um ein Steuerungspilotsignal zu empfangen, das anzeigt, dass ein Ladekabel (105) der Elektrofahrzeug-Ladestation nicht mit einem Elektrofahrzeug verbunden ist;
(b) eine Impedanzmessschaltung (140) in der Elektrofahrzeug-Ladestation, wobei die Impedanzmessschaltung an die Erfassungsschaltung (230) gekoppelt ist, wobei die Impedanzmessschaltung konfiguriert ist, um einen Impedanztest zwischen Leitern (L1, L2/N und Erde) des Ladekabels (105) durchzuführen, während das Ladekabel nicht mit einem Elektrofahrzeug verbunden ist, und
(c) eine Schutzschaltung (235) in der Elektrofahrzeug-Ladestation, wobei die Schutzschaltung an die Impedanzmessschaltung gekoppelt ist, wobei die Schutzschaltung konfiguriert ist, um eine Schließung eines Relais (130) zwischen einer Quelle elektrischer Leistung und den Leitern des Ladekabels (105) als Reaktion darauf, dass die Impedanzmessschaltung (140) einen Kurzschluss zwischen den Leitern (L1, L2/N und Erde) erkennt, zu verhindern, **dadurch gekennzeichnet, dass** die Impedanzmessschaltung an die Steuerungspilotleitung der Elektrofahrzeug-Ladestation gekoppelt ist, wobei die Impedanzmessschaltung konfiguriert ist, um ein Steuerungspilotsignal zu empfangen, das anzeigt, dass das Ladekabel der Elektrofahrzeug-Ladestation mit dem Elektrofahrzeug verbunden worden ist, und wobei die Impedanzmessschaltung konfiguriert ist, um das Durchführen des Impedanztests zwischen den Leitern des Ladekabels als Reaktion auf den Empfang des Steuerungspilotsignals zu beenden.

8. Schaltung zum Erkennen eines kurzgeschlossenen Ladekabels einer Elektrofahrzeug-Ladestation gemäß Anspruch 7, das ferner Folgendes beinhaltet:
(d) eine Warnschaltung in der Elektrofahrzeug-Ladestation, wobei die Warnschaltung an die Schutzschaltung gekoppelt ist, wobei die Warnschaltung konfiguriert ist, um als Reaktion auf das Erkennen eines Kurzschlusses zwischen den Leitern ein Warnsignal auszugeben.

9. Schaltung zum Erkennen eines kurzgeschlossenen Ladekabels einer Elektrofahrzeug-Ladestation gemäß Anspruch 7, das ferner Folgendes beinhaltet:
eine Multiplexerschaltung in der Elektrofahrzeug-Ladestation, wobei die Multiplexerschaltung konfiguriert ist, um die Impedanzmessschaltung zwischen unterschiedlichen Paaren der Leiter des Ladekabels sequentiell zu verbinden, während das Ladekabel nicht mit einem Elektrofahrzeug verbunden ist.

10. Schaltung zum Erkennen eines kurzgeschlossenen Ladekabels einer Elektrofahrzeug-Ladestation gemäß Anspruch 7, wobei das Relais durch das Verhindern einer Schließung des Relais als Reaktion auf das Erkennen eines Kurzschlusses zwischen den Leitern vor einem potentiellen Verschweißen seiner Kontakte geschützt ist.

11. Schaltung zum Erkennen eines kurzgeschlossenen Ladekabels einer Elektrofahrzeug-Ladestation gemäß Anspruch 7, wobei kurzgeschlossene Leiter für geeignete Wartungsmaßnahmen identifiziert werden.

12. Schaltung zum Erkennen eines kurzgeschlossenen Ladekabels einer Elektrofahrzeug-Ladestation gemäß Anspruch 7, wobei die Durchführung eines Impedanztests zwischen Leitern des Ladekabels an Intervallen im Zeitablauf wiederholt wird; und Steuerelektronik in der Elektrofahrzeug-Ladestation, wobei die Steuerelektronik konfiguriert ist, um Ergebnisse der Impedanztests für Paare der getesteten Leiter aufzuzeichnen.

## Revendications

1. Un procédé pour détecter un câble de recharge court-circuité d'une borne de recharge de véhicule électrique, comprenant :
(a) le fait de capter qu'un câble de recharge (105) d'une borne de recharge de véhicule électrique n'est pas raccordé à un véhicule électrique ;
(b) le fait de réaliser un essai d'impédance entre des conducteurs (L1, L2/N, et la terre) du câble de recharge tandis que le câble de recharge n'est pas raccordé à un véhicule électrique ;
(c) le fait d'empêcher la fermeture d'un contacteur (130) entre une source de puissance électrique et les conducteurs (L1, L2/N) du câble de recharge en réponse à la détection d'un court-circuit entre les conducteurs ;
(d) le fait de recevoir un signal pilote de commande indiquant que le câble de recharge de la borne de recharge de véhicule électrique est devenu raccordé au véhicule électrique, et ledit procédé étant **caractérisé en ce qu'**il comprend en sus l'étape (e) de mettre un terme à la réalisation de l'essai d'impédance entre les conducteurs du câble de recharge en réponse à la réception du signal pilote de commande.

2. Le procédé pour détecter un câble de recharge court-circuité d'une borne de recharge de véhicule électrique de la revendication 1, comprenant en sus :
(f) le fait de sortir un signal d'avertissement en réponse à la détection d'un court-circuit entre les conducteurs.

3. Le procédé pour détecter un câble de recharge court-circuité d'une borne de recharge de véhicule électrique de la revendication 1, comprenant en sus :
le fait de réaliser séquentiellement un essai d'impédance entre différentes paires des conducteurs du câble de recharge tandis que le câble de recharge n'est pas raccordé à un véhicule électrique.

4. Le procédé pour détecter un câble de recharge court-circuité d'une borne de recharge de véhicule électrique de la revendication 1, dans lequel le contacteur est protégé contre un soudage potentiel de ses contacts par le fait d'empêcher la fermeture du contacteur en réponse à la détection d'un court-circuit entre les conducteurs.

5. Le procédé pour détecter un câble de recharge court-circuité d'une borne de recharge de véhicule électrique de la revendication 1, comprenant en sus :
le fait d'identifier tout conducteur court-circuité quel qu'il soit en vue d'une action de maintenance appropriée.

6. Le procédé pour détecter un câble de recharge court-circuité d'une borne de recharge de véhicule électrique de la revendication 1, comprenant en sus :
le fait de répéter la réalisation d'un essai d'impédance entre des conducteurs du câble de recharge à intervalles au fil du temps ; et
le fait d'enregistrer des résultats des essais d'impédance pour des paires des conducteurs soumis à l'essai.

7. Un circuit pour détecter un câble de recharge court-circuité d'une borne de recharge de véhicule électrique, comprenant :
(a) un circuit de captage (230) dans une borne de recharge de véhicule électrique, le circuit de captage étant couplé à une ligne pilote de commande (115) de la borne de recharge de véhicule électrique, le circuit de captage étant configuré afin de recevoir un signal pilote de commande indiquant qu'un câble de recharge (105) de la borne de recharge de véhicule électrique n'est pas raccordé à un véhicule électrique ;
(b) un circuit de mesure d'impédance (140) dans la borne de recharge de véhicule électrique, le circuit de mesure d'impédance étant couplé au circuit de captage (230), le circuit de mesure d'impédance étant configuré afin de réaliser un essai d'impédance entre des conducteurs (L1, L2/N, et la terre) du câble de recharge (105) tandis que le câble de recharge n'est pas raccordé à un véhicule électrique, et
(c) un circuit de protection (235) dans la borne de recharge de véhicule électrique, le circuit de protection étant couplé au circuit de mesure d'impédance, le circuit de protection étant configuré afin d'empêcher la fermeture d'un contacteur (130) entre une source de puissance électrique et les conducteurs du câble de recharge (105) en réponse à la détection par le circuit de mesure d'impédance (140) d'un court-circuit entre les conducteurs (L1, L2/N, et la terre), **caractérisé en ce que** ledit circuit de mesure d'impédance est couplé à la ligne pilote de commande de la borne de recharge de véhicule électrique, le circuit de mesure d'impédance est configuré afin de recevoir un signal pilote de commande indiquant que le câble de recharge de la borne de recharge de véhicule électrique est devenu raccordé au véhicule électrique, et le circuit de mesure d'impédance est configuré afin de mettre un terme à la réalisation de l'essai d'impédance entre les conducteurs du câble de recharge en réponse à la réception du signal pilote de commande.

8. Le circuit pour détecter un câble de recharge court-circuité d'une borne de recharge de véhicule électrique de la revendication 7, comprenant en sus :
(d) un circuit d'avertissement dans la borne de recharge de véhicule électrique, le circuit d'avertissement étant couplé au circuit de protection, le circuit d'avertissement étant configuré afin de sortir un signal d'avertissement en réponse à la détection d'un court-circuit entre les conducteurs.

9. Le circuit pour détecter un câble de recharge court-circuité d'une borne de recharge de véhicule électrique de la revendication 7, comprenant en sus :
un circuit multiplexeur dans la borne de recharge de véhicule électrique, le circuit multiplexeur étant configuré afin de raccorder séquentiellement le circuit de mesure d'impédance entre différentes paires des conducteurs du câble de recharge tandis que le câble de recharge n'est pas raccordé à un véhicule électrique.

10. Le circuit pour détecter un câble de recharge court-circuité d'une borne de recharge de véhicule électrique de la revendication 7, dans lequel le contacteur est protégé contre un soudage potentiel de ses contacts par le fait d'empêcher la fermeture du contacteur en réponse à la détection d'un court-circuit entre les conducteurs.

11. Le circuit pour détecter un câble de recharge court-circuité d'une borne de recharge de véhicule électrique de la revendication 7, dans lequel des conducteurs court-circuités sont identifiés en vue d'une action de maintenance appropriée.

12. Le circuit pour détecter un câble de recharge court-circuité d'une borne de recharge de véhicule électrique de la revendication 7, dans lequel la réalisation d'un essai d'impédance entre des conducteurs du câble de recharge est répétée à intervalles au fil du temps ; et
une électronique de commande dans la borne de recharge de véhicule électrique, l'électronique de commande étant configurée afin d'enregistrer des résultats des essais d'impédance pour des paires des conducteurs soumis à l'essai.
